(19) Europäisches Patentamt / European Patent Office / Office européen des brevets

(11) **EP 3 696 514 B1**

(12) **EUROPÄISCHE PATENTSCHRIFT**

(45) Veröffentlichungstag und Bekanntmachung des Hinweises auf die Patenterteilung:
07.04.2021 Patentblatt 2021/14

(51) Int Cl.:
*G01D 18/00* *(2006.01)* *G01D 3/02* *(2006.01)*
*G01D 3/036* *(2006.01)*

(21) Anmeldenummer: **19157089.4**

(22) Anmeldetag: **14.02.2019**

(54) **SENSORANORDNUNG UND VERFAHREN ZUM BETRIEB EINER SENSORANORDNUNG**

SENSOR ASSEMBLY AND METHOD FOR OPERATING A SENSOR ASSEMBLY

AGENCEMENT DE CAPTEURS ET PROCÉDÉ DE FONCTIONNEMENT D'UN AGENCEMENT DE CAPTEURS

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR

(43) Veröffentlichungstag der Anmeldung:
19.08.2020 Patentblatt 2020/34

(73) Patentinhaber: **E+E ELEKTRONIK GES.M.B.H.**
**4209 Engerwitzdorf (AT)**

(72) Erfinder: **HAIDER, Albin**
**4211 Alberndorf (AT)**

(74) Vertreter: **Hofmann, Ernst**
**Dr. Johannes Heidenhain GmbH,**
**Patentabteilung,**
**Postfach 12 60**
**83292 Traunreut (DE)**

(56) Entgegenhaltungen:
EP-A1- 3 279 613 GB-A- 2 321 712
US-A1- 2014 019 816 US-B2- 7 731 417

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

## GEBIET DER TECHNIK

Die vorliegende Erfindung betrifft eine Sensoranordnung zur Erfassung veränderlicher physikalischer Messgrößen sowie ein Verfahren zum Betrieb einer derartigen Sensoranordnung.

## STAND DER TECHNIK

Zur Erfassung veränderlicher physikalischer Messgrößen, wie z.B. Temperatur oder Feuchte, sind Sensoranordnungen bekannt, die die entsprechenden Messgrößen nach einer geeigneten Vor- und Weiterverarbeitung über eine Signalverarbeitungseinheit als pulsweitenmodulierte Signale bzw. PWM-Signale ausgeben. Im erzeugten PWM-Signal ist die erfasste Messgröße über das Tastverhältnis p des PWM-Signals kodiert enthalten. Als Tastverhältnis p ist hierbei das Verhältnis der Dauer $t_H$ eines HIGH-Pegels zur Signal-Periodendauer $t_P = t_H + t_L$ im rechteckförmigen PWM-Signal zu verstehen, d.h. $p = t_H / t_P$; mit $t_L$ wird die Dauer eines LOW-Pegels im PWM-Signal bezeichnet. Zur Weiterverarbeitung des PWM-Signals ist üblicherweise vorgesehen, das PWM-Signal mit dem von der Messgröße abhängigen Tastverhältnis p über eine Verstärkereinheit zu demodulieren und zu verstärken und so in ein analoges Strom- oder Spannungssignal innerhalb eines bestimmten Strom- oder Spannungsbereichs umzusetzen; z.B. ist im Fall eines Stromsignals ein Strombereich zwischen 4mA und 20mA bzw. im Fall eines Spannungssignals ein Spannungsbereich ein Bereich zwischen 0V und 10V für das analoge Ausgangssignal üblich. Sowohl die der Signalverarbeitungseinheit als auch in der Verstärkereinheit eingesetzten elektronischen Bauteile unterliegen in der Praxis jedoch Schwankungen, die sich z.B. in veränderlichen Spannungen des PWM-Signals, schwankenden Offsetspannungen von Operationsverstärkern oder variierenden Widerstandstoleranzen von Verstärkerstufen auswirken können. Dies führt dazu, dass trotz identischer Messgrößen die von der Sensoranordnung ausgegebenen Messwerte in Form der analogen Strom- oder Spannungssignale von Sensoranordnung zu Sensoranordnung in nicht akzeptabler Art und Weise schwanken und damit die gewünschte Messgenauigkeit beeinträchtigen.

Aus der US 7,731,417 B2 ist zur Lösung derartiger Probleme im Fall einer Temperaturmessung bekannt, in einem dem Messbetrieb vorhergehenden Einstellmodus, eine Temperaturmessung bei einer bekannten Referenztemperatur vorzunehmen. Dabei werden mehrere Korrekturgrößen bestimmt und diese in einem Speicher abgelegt. Im Messbetrieb werden die Korrekturgrößen dann herangezogen, um die Pulsbreite des PWM-Signals temperaturabhängig zu korrigieren. Die Erzeugung des PWM-Signals erfolgt in der vorgeschlagenen Lösung über analoge Signalverarbeitungs-Komponenten, denen die Korrekturgrößen aus dem Speicher zugeführt werden. Hierzu sind aufwändige D/A-Wandler erforderlich, um die abgespeicherten digitalen Korrekturgrößen in geeignete Analogsignale umzusetzen. Je höher die Anforderungen an die Genauigkeit des PWM-Signals, desto größer werden als Konsequenz auch die Anforderungen an die Auflösung der D/A-Wandler; der schaltungstechnische Aufwand steigt somit im Fall einer gewünschten höheren Auflösung erheblich.

## ZUSAMMENFASSUNG DER ERFINDUNG

Der vorliegenden Erfindung liegt die Aufgabe zugrunde, eine Sensoranordnung zur Erfassung veränderlicher physikalischer Messgrößen zu schaffen, die eine hochgenaue und zuverlässige Ausgabe von analogen Strom- oder Spannungssignalen bezüglich der erfassten physikalischen Messgrößen mit möglichst geringem schaltungstechnischen Aufwand ermöglicht.

Diese Aufgabe wird erfindungsgemäß durch eine Sensoranordnung mit den Merkmalen des Anspruchs 1 gelöst.

Ferner liegt dieser Erfindung die Aufgabe zugrunde, ein Verfahren zum Betrieb einer Sensoranordnung zur Erfassung veränderlicher physikalischer Messgrößen zu schaffen, die eine hochgenaue Ausgabe von analogen Strom- oder Spannungssignalen bezüglich der erfassten physikalischen Messgrößen ermöglicht.

Diese Aufgabe wird erfindungsgemäß durch ein Verfahren mit den Merkmalen des Anspruchs 9 gelöst.

Vorteilhafte Ausführungen der erfindungsgemäßen Sensoranordnung und des erfindungsgemäßen Verfahrens ergeben sich aus den Maßnahmen, die in den jeweils abhängigen Ansprüchen aufgeführt sind.

Die erfindungsgemäße Sensoranordnung umfasst

- mindestens einen Sensor, der veränderliche physikalische Messgrößen erfasst und ausgangsseitig ein Sensor-Rohsignal bereitstellt,
- eine digitale Signalverarbeitungseinheit zur Vorverarbeitung des vom Sensor bereitgestellten Sensor-Rohsignals in ein Sensor-Signal, wobei die Signalverarbeitungseinheit das Sensor-Signal weiterverarbeitet und dabei in ein pulsweitenmoduliertes Ausgangssignal mit einem von der Messgröße abhängigen Tastverhältnis umsetzt, wozu in einer Speichereinheit mehrere anordnungsspezifische Korrekturparameter abgelegt sind, welche die Signalverarbeitungseinheit zur Umsetzung des Sensor-Signals in das pulsweitenmodulierte Ausgangssignal heranzieht, wobei als anordnungsspezifische Korrekturparameter zumindest ein minimaler Tastverhältnisparameter-Grenzwert und ein maximaler Tastverhältnisparameter-Grenzwert in der Speichereinheit abgelegt ist und - eine Verstärkereinheit, die das pulsweitenmodulierte Ausgangssignal in ein analoges Spannungs- oder Stromsignal umsetzt.

Mit Vorteil ist in der digitalen Signalverarbeitungseinheit eine anordnungsspezifische Umsetzvorschrift abgelegt, die einen linearen Zusammenhang zwischen dem Messwert des Sensor-Signals und einem Tastverhältnisparameter des pulsweitenmodulierten Ausgangssignals beschreibt.

Ferner ist möglich, dass in der Speichereinheit noch zusätzlich ein minimaler Sensor-Grenzmesswert und ein maximaler Sensor-Grenzmesswert abgelegt sind, die den Sensor-Messbereich begrenzen,

Als anordnungsspezifische Umsetzvorschrift kann die Beziehung

$$PWM\_OUT\_NOW = MV\_NOW \cdot k_{PWM} + d_{PWM}$$

in der digitalen Signalverarbeitungseinheit abgelegt sein, mit PWM_OUT_NOW := Tastverhältnisparameter des PWM-

$$k_{PWM} := \frac{(PWM\_OUT\_MAX - PWM\_OUT\_MIN)}{(MV\_OUT\_MAX - MV\_OUT\_MIN)}$$

Signals MV_NOW := Messwert des Sensors

$d_{PWM}$ := PWM_OUT_MIN - MV_OUT_MIN · $k_{PWM}$
PWM_OUT_MAX := maximaler Tastverhältnisparameter-Grenzwert
PWM_OUT_MIN := minimaler Tastverhältnisparameter-Grenzwert
MV_OUT_MAX := maximaler Sensor-Grenzmesswert
MV_OUT_MIN := minimaler Sensor-Grenzmesswert

Es kann vorgesehen sein, dass der mindestens eine Sensor, die digitale Signalverarbeitungseinheit sowie die Speichereinheit gemeinsam in einem ASIC angeordnet sind und die Verstärkereinheit getrennt vom ASIC ausgebildet ist.

Hierbei kann die Speichereinheit als nichtflüchtige Speichereinheit ausgebildet sein.

In einer möglichen Ausführungsform kann die Verstärkereinheit als Verstärkerschaltung mit einem Tiefpass ausgebildet sein.

Mit Vorteil sind zwei Sensoren vorgesehen, von denen ein erster Sensor als Temperatursensor und ein zweiter Sensor als Feuchtesensor ausgebildet ist.

Das erfindungsgemäße Verfahren dient zum Betrieb einer Sensoranordnung in einem Messbetrieb und in einem Kalibrierbetrieb.

Hierbei wird im Messbetrieb

- über mindestens einen Sensor eine veränderliche physikalische Messgröße erfasst und ausgangsseitig ein Sensor-Rohsignal bereitgestellt, und
- über eine digitale Signalverarbeitungseinheit das vom Sensor bereitgestellte Sensor-Rohsignal in ein Sensor-Signal vorverarbeitet und das Sensor-Signal in ein pulsweitenmoduliertes Ausgangssignal mit einem von der Messgröße abhängigen Tastverhältnis umgesetzt, und
- über eine Verstärkereinheit das pulsweitenmodulierte Ausgangssignal in ein analoges Spannungs- oder Stromsignal umgesetzt.

In einem dem Messbetrieb vorhergehenden Kalibrierbetrieb werden in einer Speichereinheit mehrere anordnungsspezifische Korrekturparameter abgelegt, welche von der Signalverarbeitungseinheit im Messbetrieb zur Umsetzung des Sensor-Signals in das pulsweitenmodulierte Ausgangssignal herangezogen werden, wobei als anordnungsspezifische Korrekturparameter zumindest ein minimaler Tastverhältnisparameter-Grenzwert und ein maximaler Tastverhältnisparameter-Grenzwert in der Speichereinheit abgelegt werden.

Vorzugsweise wird im Kalibrierbetrieb in der digitalen Signalverarbeitungseinheit eine anordnungsspezifische Umsetzvorschrift abgelegt, die einen linearen Zusammenhang zwischen dem Messwert des Sensor-Signals und einem Tastverhältnisparameter des pulsweitenmodulierten Ausgangssignals beschreibt.

Es ist außerdem möglich, dass ferner ein minimaler Sensor-Grenzmesswert und ein maximaler Sensor-Grenzmesswert in der Speichereinheit abgelegt werden, die den Sensor-Messbereich begrenzen.

In einer möglichen Ausführungsform wird als anordnungsspezifische Umsetzvorschrift die Beziehung

$$PWM\_OUT\_NOW = MV\_NOW \cdot k_{PWM} + d_{PWM}$$

in der digitalen Signalverarbeitungseinheit abgelegt, mit PWM_OUT_NOW := Tastverhältnisparameter des PWM-Signals MV_NOW := Messwert des Sensor-Signals

$$k_{PWM} := \frac{(PWM\_OUT\_MAX - PWM\_OUT\_MIN)}{(MV\_OUT\_MAX - MV\_OUT\_MIN)}$$

$d_{PWM}$ := PWM_OUT_MIN - MV_OUT_MIN $\cdot$ $k_{PWM}$
PWM_OUT_MAX := maximaler Tastverhältnisparameter-Grenzwert
PWM_OUT_MIN := minimaler Tastverhältnisparameter-Grenzwert
MV_OUT_MAX := maximaler Sensor-Grenzmesswert
MV_OUT_MIN := minimaler Sensor-Grenzmesswert

Es ist desweiteren möglich, dass der Kalibrierbetrieb durchgeführt wird, ohne die Temperatur der Sensoranordnung zu verändern.

Über die erfindungsgemäßen Maßnahmen kann nunmehr eine hochgenaue Erfassung der jeweiligen Messwerte im Fall einer Ausgabe analoger Spannungs- oder Stromsignale sichergestellt werden. Dies ist auch dann gewährleistet, wenn einzelne Komponenten der entsprechenden Sensoranordnung herstellbedingte Bauteilschwankungen aufweisen.

Desweiteren ermöglichen die erfindungsgemäßen Maßnahmen, dass zur Bereitstellung der hochgenauen, ausgangsseitigen analogen Strom- oder Spannungssignale der erforderliche Schaltungsaufwand erheblich reduziert werden kann. Es sind aufgrund der vorgesehenen digitalen Signalverarbeitung zur Erzeugung des PWM-Signals insbesondere keine aufwändigen Komponenten wie z.B. D/A-Wandler erforderlich.

Die vorgesehene digitale Signalverarbeitung ermöglicht ferner eine äußerst flexible Einstellung des Zusammenhangs zwischen der jeweiligen Messgröße und dem Tastverhältnis des PWM-Signals.

Weitere Einzelheiten und Vorteile der vorliegenden Erfindung seien anhand der nachfolgenden Beschreibung von Ausführungsbeispielen der erfindungsgemäßen Sensoranordnung und des erfindungsgemäßen Verfahrens in Verbindung mit den Figuren erläutert.

## KURZE BESCHREIBUNG DER ZEICHNUNGEN

Es zeigt

Figur 1      ein stark schematisiertes Blockschaltbild eines Ausführungsbeispiels der erfindungsgemäßen Sensoranordnung;

Figur 2a      eine schematische Detail-Darstellung eines Teils des Blockschaltbilds in Figur 1 zur beispielhaften Erläuterung der Umsetzung eines PWM-Signals in ein analoges Spannungssignal;

Figur 2b      eine weitere schematische Darstellung zur Umsetzung eines PWM-Signals in ein analoges Spannungssignal über eine Linearinterpolation;

Figur 3      eine schematische Darstellung zur Umsetzung eines PWM-Signals in ein analoges Spannungssignal.

## BESCHREIBUNG DER AUSFÜHRUNGSFORMEN

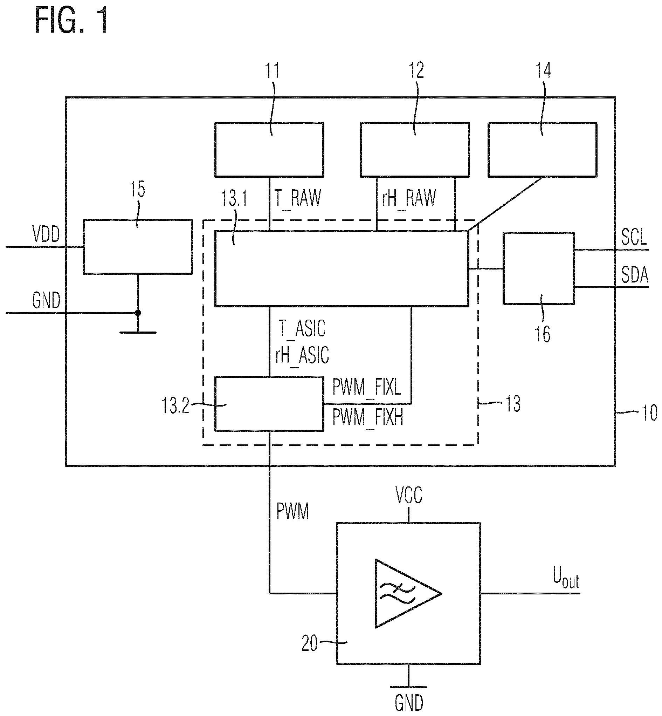

Ein Ausführungsbeispiel der erfindungsgemäßen Sensoranordnung zur Erfassung veränderlicher physikalischer Messgrößen ist in Figur 1 in einem stark schematisierten Blockschaltbild dargestellt.

Die Sensoranordnung weist hierbei zum einen eine integrierte Schaltung in Form eines ASICs 10 auf, der verschiedene analoge und digitale Signalverarbeitungs-Komponenten umfasst; deren Funktionen werden nachfolgend noch im Detail beschrieben. Der ASIC 10 ist als Mixed-Signal-ASIC ausgebildet und zur Verarbeitung analoger und digitaler Signale geeignet.

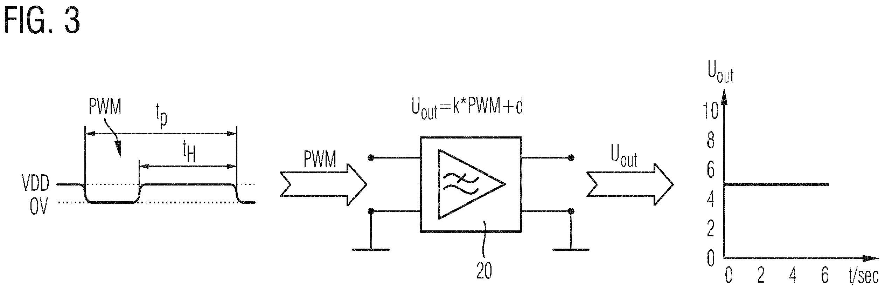

Zum anderen umfasst die erfindungsgemäße Sensoranordnung eine Verstärkereinheit 20, die ein vom ASIC 10 geliefertes, messgrößenabhängiges PWM-Signal PWM in ein analoges Ausgangssignal umsetzt. Im vorliegenden Ausführungsbeispiel ist die Umsetzung in ein analoges Spannungssignal $U_{OUT}$ vorgesehen, wie dies auch in Figur 3 noch detaillierter dargestellt ist. Desweiteren ist aus Figur 3 ersichtlich, dass das PWM-Signal einen im wesentlichen rechteckförmigen Verlauf zwischen einem LOW-Pegel (0V) und einem HIGH-Pegel (VDD) aufweist, wobei der HIGH-Pegel der Versorgungsspannung VDD des ASICs 10 entspricht. Das derart erzeugte, analoge Spannungssignal $U_{OUT}$ wird dann an eine nicht in den Figuren gezeigte Folgeelektronik zur Weiterverarbeitung ausgegeben. In einer möglichen Ausführungsform ist die Verstärkereinheit 20 als Verstärkerschaltung mit einem Tiefpass ausgebildet; der Tiefpass kann hierbei als Tiefpass erster oder höherer Ordnung ausgebildet sein. Das heißt, neben der Filterung und Umsetzung des PWM-Signals PWM erfolgt über die Verstärkereinheit 20 noch eine geeignete Verstärkung des resultierenden analogen Signals $U_{OUT}$. Hierbei kann z.B. eine Verstärkung der Versorgungsspannung VDD des ASICs 10 von VDD = 3.3V auf 10V im analogen Spannungssignal UOUT erfolgen.

Mit dem Bezugszeichen 15 wird in der Figur ein LDO- (Low Drop Out)-Spannungsregler bezeichnet, über den die Spannungsversorgung des ASICs 10 erfolgt. Der LDO-Spannungsregler 15 verringert hierbei die externe Versorgungsspannung auf einen Spannungswert, der für den ASIC geeignet ist, z.B. auf 1,8V. Von der erfindungsgemäßen Sensoranordnung wird im vorliegenden Beispiel ein analoges Spannungssignal im Bereich zwischen 0 V und 10 V an die Folgeelektronik ausgegeben.

Im dargestellten Beispiel ist die Erfassung der Temperatur T und der Feuchte rH als veränderliche physikalische Messgrößen vorgesehen. Zur Erfassung der Messgrößen T, rH sind im Analogteil des ASICs 10 ein erster Sensor 11 zur Temperaturmessung sowie ein zweiter Sensor 12 zur Feuchtemessung ausgebildet. Der Sensor 11 zur Temperaturmessung kann einen Transistor umfassen, bei dem eine temperaturabhängige Basis-Emitter-Spannung mit Hilfe eines AD-Wandlers gemessen und in ein digitales Signal umgewandelt wird. Als Sensor 12 zur Feuchtemessung kann ein Plattenkondensator verwendet werden, dessen feuchteabhängige Kapazität mittels einer Kapazitätsmessstufe erfasst und in ein digitales Signal gewandelt wird. Die in den ASIC 10 integrierten Sensoren 11, 12 stellen somit ausgangsseitig Sensor-Rohsignale T_RAW, rH_RAW bezüglich der jeweiligen Messgrößen T, rH bereit.

Bei den Sensor-Rohsignalen T_RAW, rH_RAW handelt es sich um digitale Datenwörter, z.B. in Form von 16-Bit-Datenwörtern, die von den Sensoren 11, 12 jeweils einer nachgeordneten digitalen Signalverarbeitungseinheit 13 im ASIC 10 zugeführt werden. Die digitale Signalverarbeitungseinheit 13 ist als digitaler Signalprozessor im ASIC 10 ausgebildet und dient u.a. zur Vor- und Weiterverarbeitung der Sensor-Rohsignale T_RAW, rH_RAW in Sensor-Signale T_ASIC, rH_ASIC. Gemäß der Darstellung in Figur 1 umfasst die digitale Signalverarbeitungseinheit 13 zumindest zwei separate Funktionsblöcke 13.1, 13.2; es sei darauf hingewiesen, dass diese Darstellung lediglich zur folgenden verständlicheren Erläuterung der Funktionsweise der Signalverarbeitung in der digitalen Signalverarbeitungseinheit 13 gewählt wurde und nicht einschränkend in Bezug auf die Ausbildung der digitalen Signalverarbeitungseinheit 13 zu verstehen ist.

In der Signalverarbeitungseinheit 13 bzw. im ersten Funktionsblock 13.1 derselbigen erfahren die Sensor-Rohsignale T_RAW, rH_RAW zunächst eine Vorverarbeitung. Dabei kann etwa eine Linearisierung erfolgen, über die eventuell vorhandene Nichtlinearitäten der Sensoren 11, 12 kompensiert werden. Ferner können im Rahmen der Vorverarbeitung Fehler korrigiert werden, die durch Schwankungen in der Fertigung der Sensoren 11, 12 verursacht werden. Ebenso ist es möglich Temperaturquerempfindlichkeiten des Feuchtesensors und die Eigenerwärmung des ASICs 10 zu kompensieren usw.. Im Zusammenhang mit der Vorverarbeitung der Sensor-Rohsignale T_RAW, rH_RAW sei darauf hingewiesen, dass die Vorverarbeitung grundsätzlich auf verschiedenste Art und Weise erfolgen kann; es handelt sich hierbei um keine erfindungswesentlichen Maßnahmen.

Die im ersten Funktionsblock 13.1 der digitalen Signalverarbeitungseinheit 13 aus den Sensor-Rohsignalen T_RAW, rH_RAW im Rahmen der Vorverarbeitung erzeugten Signale werden nachfolgend als Sensor-Signale T_ASIC bzw. rH_ASIC bezeichnet. Im zweiten Funktionsblock 13.2 der digitalen Signalverarbeitungseinheit 13 werden die Sensor-Signale T_ASIC, rH_ASIC anschließend weiterverarbeitet und in ein pulsweitenmoduliertes Ausgangssignal PWM umgesetzt, das ein von der jeweiligen Messgröße T, rH abhängiges Tastverhältnis p besitzt. Wie bereits oben erläutert, ist als Tastverhältnis p das Verhältnis der Dauer $t_H$ eines HIGH-Pegels (z.B. 3.3V) zur Signal-Periodendauer $t_P = t_H + t_L$ im rechteckförmigen PWM-Signal zu verstehen, d.h. es gilt $p = t_H / t_P$; mit $t_L$ wird die Dauer eines LOW-Pegels (z.B. 0V) im PWM-Signal bezeichnet. Bei einer durch eine feste Taktfrequenz vorgegebenen Signal-Periodendauer tp ist die Dauer $t_H$ proportional zum Wert der Messgröße T bzw. rH. Im Fall einer PWM-Auflösung von 16 Bit kann die Signal-Periodendauer tp somit in $2^{16}$ = 65.536 Intervalle bzw. Schritte unterteilt werden. Damit können Werte der Messgröße T, rH im Bereich zwischen 0 (PWM-Signal durchgängig auf LOW-Pegel) und 65.535 (PWM-Signal fast durchgängig auf HIGH-Pegel) über das Tastverhältnis p des PWM-Signals PWM kodiert und ausgegeben werden. Nachfolgend sei die Dauer $t_H$ des HIGH-Pegels auch als Tastverhältnis-Parameter oder PWM-Wert bezeichnet. Über den Tastverhältnis-Parameter ist dann das jeweilige Tastverhältnis p eindeutig charakterisiert; der Tastverhältnis-Parameter kann bei einer Auflösung von 16 Bit Werte im Bereich zwischen 0 und 65.535 annehmen.

Um die eingangs diskutierten Probleme mit Bauteilschwankungen zu minimieren, ist für die erfindungsgemäße Sensoranordnung vorgesehen, dass diese in zwei verschiedenen Modi betreibbar ist, nämlich in einem Messbetrieb und in einem Kalibrierbetrieb. Im Messbetrieb erfolgt die Erfassung der jeweiligen physikalischen Messgrößen T, rH, die Umsetzung der Messgrößen in ein pulsweitenmoduliertes Ausgangssignal PWM und nachfolgend die Umsetzung des PWM-Signals PWM in ein zur Weiterverarbeitung geeignetes analoges Spannungssignal $U_{OUT}$. Der dem Messbetrieb vorhergehende Kalibrierbetrieb dient zur Bestimmung von mehreren anordnungsspezifischen Korrekturparametern der Sensoranordnung, die in einer Speichereinheit 14 abgelegt werden, welche ebenfalls im ASIC 10 integriert ist. Die Speichereinheit 14 ist vorzugsweise als nichtflüchtige Speichereinheit, z.B. als EEPROM, ausgebildet. Zur Durchführung der Kalibration gibt es grundsätzlich verschiedene Möglichkeiten. So kann diese etwa bereits bei der Fertigung der Sensoranordnung werksseitig erfolgen oder aber erst später vom jeweiligen Anwender vorgenommen werden. Die für jede einzelne Sensoranordnung im Kalibrierbetrieb ermittelten spezifischen Korrekturparameter werden bei der Signalverarbeitung in der digitalen Signalverarbeitungseinheit 13 im Messbetrieb herangezogen, um ein die Messgröße kodierendes PWM-Signal PWM mit einem anordnungsspezifischen Tastverhältnis p zu erzeugen. Damit können eventuelle Bauteilschwankungen in unterschiedlichen Sensoranordnungen berücksichtigt und auf diese Art und Weise die korrekte Bereitstellung eines messgrößenabhängigen Ausgangssignals $U_{OUT}$ gewährleistet werden.

Nachfolgend wird zur weiteren Beschreibung der erfindungsgemäßen Sensoranordnung bzw. der zum Betrieb derselben vorgesehenen Mess- und Kalibriermodi beispielhaft für die Messgröße Temperatur T die Bestimmung der anordnungsspezifischen Korrekturparameter und deren Nutzung im Messbetrieb erläutert. Völlig analog hierzu kann grundsätzlich im Fall der Messgröße Feuchte rH oder eventueller weiterer Messgrößen vorgegangen werden.

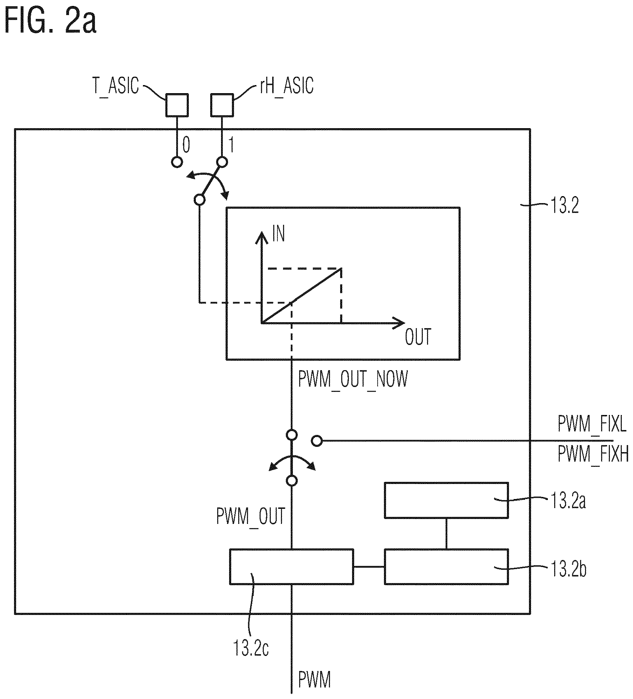

Zur Durchführung des Kalibrierbetriebs bzw. der Bestimmung der anordnungsspezifischen Korrekturparameter im Kalibrierbetrieb umfasst der ASIC 10 der erfindungsgemäßen Sensoranordnung eine Schnittstelle 16, die z.B. als bekannte I2C-Schnittstelle ausgebildet ist. Über die Schnittstelle 16 und die entsprechenden Signalübertragungsleitungen SCL, SCA ist die Sensoranordnung bzw. der ASIC 10 mit einer nachgeordneten - nicht in Figur 1 dargestellten - Steuereinheit verbunden, beispielsweise über einen I2C-USB-Wandler mit einem PC. Es ist über die Schnittstelle 16 möglich, die Ausgabe eines PWM-Signals PWM vom ASIC 10 an die Verstärkereinheit 20 zu veranlassen, das ein festes bzw. definiert vorgegebenes Tastverhältnis p respektive einen fest vorgegebenen Tastverhältnis-Paramater bzw. PWM-Wert aufweist. Konkret vorgesehen ist im Rahmen des Kalibrierbetriebs in einer möglichen Ausführungsform des erfindungsgemäßen Verfahrens hierbei die Ausgabe eines ersten PWM-Signals mit dem Tastverhältnis-Parameter bzw. PWM-Wert PWM_FIXL sowie eines zweiten PWM-Signals mit dem Tastverhältnis-Parameter bzw. PWM-Wert PWM_FIXH. In Figur 2a, die den zweiten Funktionsblock 13.2 der digitalen Signalverarbeitungseinheit 13 zeigt, wird über den unteren Schalter die Umschaltmöglichkeit zwischen Mess- und Kalibrierbetrieb angedeutet. Im Kalibrierbetrieb werden hierbei den Komponenten 13.2a - 13.2c die Tastverhältnis-Parameter PWM_FIXL, PWM_FIXH zur Erzeugung entsprechender PWM-Signale PWM zugeführt werden, im Messbetrieb hingegen der Tastverhältnis-Parameter PWM_OUT_NOW bzgl. des aktuellen Messwerts.

Mit PWM_MAX wird im folgenden der Wert des maximal ausgebbaren Tastverhältnis-Parameters bezeichnet. Vorausgesetzt sei in der entsprechenden Sensoranordnung ferner eine PWM-Auflösung von 16 Bit, d.h. die möglichen Tastverhältnis-Parameter bzw. PWM-Werte liegen im Bereich zwischen 0 und 65.535; die Versorgungsspannung VDD für den ASIC 10 beträgt VDD = 3.3V.

Wie in Figur 3 schematisch angedeutet, wird von der Verstärkereinheit 20 das jeweilige PWM-Signal PWM mit einem definierten PWM-Wert PWM_OUT in ein analoges Spannungssignal $U_{OUT}$ gemäß folgendem Zusammenhang umgesetzt:

$$U_{OUT} = k \cdot PWM\_OUT + d \qquad \text{(Gl. 1a)}$$

bzw.

$$PWM\_OUT = (U_{OUT} - d) / d \qquad \text{(Gl. 1b)}$$

mit:

$U_{OUT}$:=         Wert des analogen Spannungssignals
PWM_OUT :=    Tastverhältnis-Paramater bzw. PWM-Wert des PWM-Signals
k :=            Verstärkungsfaktor der Verstärkereinheit
d :=            Offset der Verstärkereinheit

Im Beispiel soll eine mögliche Temperaturmessung im Bereich zwischen - 40°C und + 60°C skaliert werden. Das heißt, die minimale Ausgangstemperatur T_OUT_MIN beträgt T_OUT_MIN = - 40°C, die maximale Ausgangstemperatur T_OUT_MAX beträgt T_OUT_MAX = + 60°C. Der minimalen Ausgangstemperatur T_OUT_MIN soll ein Wert OUT_MIN des minimalen analoges Spannungssignals $U_{OUT}$ von OUT_MIN = 0V entsprechen, der maximalen Ausgangstemperatur T_OUT_MAX ein maximales analoges Spannungssignal $U_{OUT}$ mit OUT_MAX = 10V.

Zunächst wird im Kalibrierbetrieb über die Schnittstelle 16 veranlasst, dass der ASIC 10 ein erstes PWM-Signal mit einem unteren, festen Tastverhältnisparameter-Wert PWM_FIXL = 10.000 ausgibt. Für diesen fest eingestellten PWM-Wert wird dann der Wert OUT_LOW des nach der Verstärkereinheit 20 resultierenden analogen Ausgangssignals $U_{OUT}$ gemessen; dieser ergibt sich beispielsweise zu OUT_LOW = 0,573V.

Anschließend erfolgt die Ausgabe eines weiteren, zweiten PWM-Signals PWM mit einem oberen, festen Tastverhältnisparameter-Wert PWM_FIXH = 50.000; das hierzu gemessene analoge Ausgangssignal $U_{OUT}$ besitzt den beispielhaften Wert OUT_HIGH = 9,573V.

Daraus können dann für die spezifische, zu kalibrierende Sensoranordnung die Parameter k und d aus Gleichung 1) und damit der tatsächliche Zusammenhang zwischen Tastverhältnis p bzw. dem zugehörigen PWM-Wert PWM_OUT und dem ausgegebenen Wert $U_{OUT}$ des analogen Signals $U_{OUT}$ folgendermaßen allgemein (Gl. 2a, 2b) bzw. im speziellen für das erläuterte Beispiel bestimmt werden:

$$k = \frac{(OUT\_HIGH - OUT\_LOW)}{(PWM\_FIXH - PWM\_FIXL)} \qquad \text{(Gl. 2a)}$$

$$= \frac{(9,573\ V - 0,573\ V)}{(50.000 - 10.000)} = 0,000225\ \frac{V}{LSB}$$

$$d = OUT\_LOW - PWM\_FIXL \cdot k \qquad \text{(Gl. 2b)}$$

$$= 0,573 - 10.000 \cdot 0,000225 = -1,677V$$

mit:

k := Verstärkungsfaktor der Verstärkereinheit
d := Offset der Verstärkereinheit
PWM_FIXL := unterer Tastverhältnisparameter-Wert
PWM_FIXH := oberer Tastverhältnisparameter-Wert
OUT_MIN := Wert des analogen Ausgangssignals $U_{OUT}$ bei minimaler Temperatur
OUT_HIGH := gemessener Wert des Ausgangssignals $U_{OUT}$ bei oberem Tastverhältnisparameter-Wert PWM_FIXH
OUT_LOW := gemessener Wert des Ausgangssignals $U_{OUT}$ bei unterem Tastverhältnisparameter-Wert PWM_FIXL

Die Verstärkereinheit 20 muss grundsätzlich derart ausgelegt werden, dass in jedem Toleranzfall ein zugehöriger PWM-Wert existiert. Dies bedeutet, dass der vom ASIC 10 auszugebende PWM-Wert immer zwischen PWM_OUT = 0 und PWM_OUT = PWM_MAX liegen muss.

Damit kann man nun individuell für die gerade kalibrierte Sensoranordnung die PWM-Werte PWM_OUT_MIN und PWM_OUT_MAX bestimmen, welche erforderlich sind, um über die Verstärkereinheit 20 exakt die Werte OUT_MIN = 0V und OUT_MAX = 10V für das analoge Spannungssignal $U_{OUT}$ ausgeben zu können. Die entsprechenden PWM-Werte PWM_OUT_MIN und PWM_OUT_MAX ergeben sich allgemein aus Gleichung 1b) und für das erläuterte spezielle Beispiel hierbei folgendermaßen:

$$PWM\_OUT\_MIN = \frac{OUT\_MIN - d}{k} \qquad \text{(Gl. 3a)}$$

$$= \frac{0\ V + 1,667}{0,000225} = 7.453$$

$$PWM\_OUT\_MAX = \frac{OUT\_MAX - d}{k} \qquad \text{(Gl. 3b)}$$

$$= \frac{(10,000\ V + 1,677\ V)}{0,000225} = 51.898$$

mit:

PWM_OUT_MIN := erforderlicher PWM-Wert zur Ausgabe von OUT_MIN = 0V im analogen Spannungssignal $U_{OUT}$
PWM_OUT_MAX := erforderlicher PWM-Wert zur Ausgabe von OUT_MAX = 10V im analogen Spannungssignal $U_{OUT}$
k := Verstärkungsfaktor der Verstärkereinheit
d := Offset der Verstärkereinheit
OUT_MIN := Wert des analogen Ausgangssignals $U_{OUT}$ bei minimaler Temperatur
OUT_MAX := Wert des analogen Ausgangssignals $U_{OUT}$ bei maximaler Temperatur

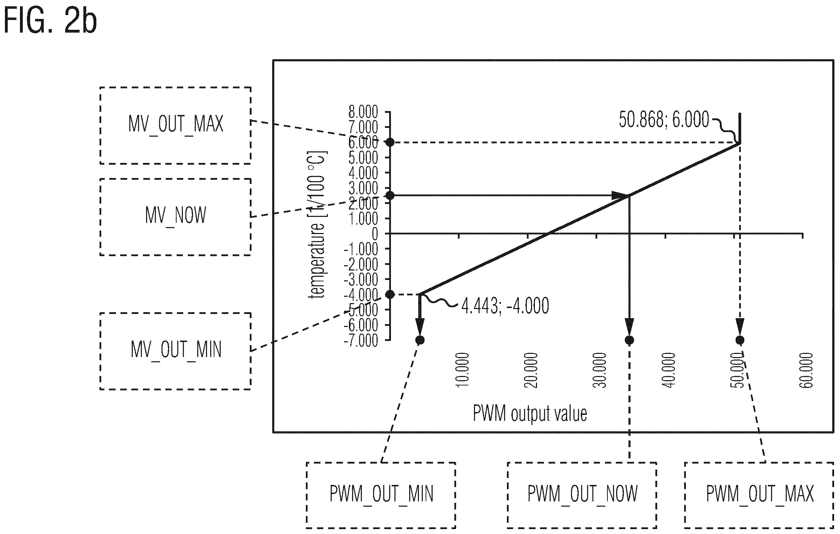

Um einem bestimmten Messwert der Messgröße T ein bestimmtes Tastverhältnis des PWM-Signals bzw. einen entsprechenden Tastverhältnisparameter respektive PWM-Wert zuzuordnen, ist in der digitalen Signalverarbeitungseinheit 13 eine anordnungsspezifische Zuordnungsvorschrift abgelegt. Diese beschreibt in Form einer Linearinterpolation einen linearen Zusammenhang zwischen dem jeweiligen aktuellen Messwert MV_NOW des Sensor-Signals T_ASIC und dem zugehörigen Tastverhältnisparamater PWM_OUT_NOW. Die entsprechenden Zusammenhänge sind stark schematisiert in den Figuren 2a und 2b dargestellt, wobei Figur 2a den zweiten Funktionsblock 13.2 der digitalen Signalverarbeitungseinheit 13 und Figur 2b eine Detail-Darstellung zur erfolgenden Linearinterpolation zeigt.

Anhand des konkret erläuterten Beispiels für die Temperaturmessung sei nachfolgend die Linearinterpolation mit Hilfe von Figur 2b erläutert.

Die entlang der y-Achse eingetragenen Werte MV_OUT_MIN und MV_OUT_MAX stellen die unteren und oberen Grenzwerte der auszugebenden Temperatur T in Schritten von 1/100 °C dar. Für dieses Beispiel gilt somit:

$$MV\_OUT\_MIN = -4.000 \ (= T\_OUT\_MIN *100)$$

$$MV\_OUT\_MAX = 6.000 \ (= T\_OUT\_MAX *100)$$

Damit wird bei der minimalen Temperatur T_OUT_MIN = - 40°C für das analoge Spannungssignal $U_{OUT}$ die minimale Spannung OUT_MIN = 0V und bei der maximalen Temperatur T_OUT_MAX = 60°C die maximale Spannung OUT_MAX = 10,000V ausgegeben.

Die Größen PWM_OUT_MIN und PWM_OUT_MAX, d.h. der minimale und der maximale Tastverhältnisparameter-Grenzwert stellen somit anordnungsspezifische Korrekturparameter dar, die nach der Durchführung des Kalibrierbetriebs für die jeweilige Sensoranordnung werks- oder kundenseitig in einer Speichereinheit 14 im ASIC 10 abgelegt werden. Sie werden im Messbetrieb herangezogen, um eventuelle Bauteilschwankungen zu korrigieren und bleiben in der vorzugsweise nichtflüchtigen Speichereinheit 14 über die Lebensdauer der Sensoranordnung dauerhaft abgelegt.

Neben den anordnungsspezifische Korrekturparametern PWM_OUT_MIN, PWM_OUT_MAX können in der Speichereinheit 14 desweiteren auch die Größen MV_OUT_MIN, MV_OUT_MAX, also die unteren und oberen Sensor-Grenzmesswerte der auszugebenden Temperatur T abgelegt werden, durch die der gewünschte Messbereich begrenzt wird. Im Bedarfsfall kann dieser durch eine Änderung der entsprechenden Sensor-Grenzmesswerte auch später noch geeignet verändert und an die jeweiligen Messanforderungen angepasst werden.

Für einen aktuell erfassten Messwert MV_NOW des jeweiligen Sensors ergibt sich der entsprechende Tastverhältnisparameter bzw. PWM-Wert PWM_OUT_NOW des zugehörigen PWM-Signals dann durch eine Linearinterpolation zwischen den beiden Grenzwerten PWM_OUT_MIN, PWM_OUT_MAX entlang der durchgezogenen Linie in Figur 2b. Diese Linearinterpolation ist als anordnungsspezifische Umsetzungsvorschrift in der digitalen Signalverarbeitungseinheit 13 abgelegt. Es gilt hierbei

$$PWM\_OUT\_NOW = k_{PWM} \cdot MV\_OUT\_NOW + d_{PWM} \qquad (Gl. \ 4)$$

mit:

PWM_OUT_NOW := Tastverhältnisparameter des PWM-Signals
MV_NOW := Messwert des Sensors

$$k_{PWM} := \frac{\left( PWM_{OUT_{MAX}} - PWM_{OUT_{MIN}} \right)}{\left( MV_{OUT_{MAX}} - MV_{OUT_{MIN}} \right)}$$

$$d_{PWM} = PWM\_OUT\_MIN - MV\_OUT\_MIN * k_{PWM}$$

Im konkreten Beispiel resultiert für die beiden Größen $k_{PWM}$ und $d_{PWM}$ mit den oben angegeben Werten:

$$k_{PWM} = \frac{(51.898 - 7453)}{(6.000 + 4.000)} = 4{,}4444$$

$$d_{PWM} = 7453 + 4.000 * 4{,}444444 = 25.230{,}78 \cong 25.231$$

Liegt z.B. ein aktueller Temperaturmesswert von 25,00°C vor, so kann der zugehörige PWM-Wert PWM_OUT_NOW des im Funktionsblock 13.2 zu erzeugenden PWM-Signals PWM folgendermaßen bestimmt werden:

$$MV\_NOW = T\_AKT * 100 = 25{,}00 * 100 = 2.500$$

$$PWM\_OUT\_NOW = MV\_NOW * k_{PWM} + d_{PWM} = 2.500 * 4{,}4444 + 25.231$$
$$= 36.342{,}25 \cong 36.342$$

Im Fall eines derart gewählten PWM-Werts PWM_OUT_NOW = 36.342 ist mit Gleichung 1a) sichergestellt, dass das analoge Spannungssignal $U_{OUT}$ ausgangsseitig exakt den Wert 6,49995V besitzt. Die Abweichung zu 6,5000V ergibt sich aus der Diskretisierung des Wertes für PWM_OUT_NOW von einer reellen Zahl zu einer 16-Bit Zahl.

Nachdem der erforderliche PWM-Wert PWM_OUT_NOW über die erfolgte Linearinterpolation im zweiten Funktionsblock 13.2 der digitalen Signalverarbeitungseinheit 13 bestimmt wurde, kann dann anschließend mit diesem Wert über die PWM-Komparatorstufe 13.2c, die PWM-Takterzeugungseinheit 13.2a und die PWM-Zählereinheit 13.2b das rechteckförmige Signal PWM erzeugt und an die Verstärkereinheit 20 übergeben werden. Hierbei wird die PWM-Zählereinheit 13.2b mit einem Taktsignal der PWM-Takterzeugungseinheit 13.2a gespeist und zählt z.B. mit jeder steigenden Taktsignal-Flanke nach oben. Solange nach oben gezählt wird, gibt die PWM-Komparatorstufe 13.2a am Ausgang ein HIGH-Signal (VDD) aus. Wird dabei der Wert PWM_OUT erreicht, so schaltet die PWM-Komparatorstufe 13.2a das Ausgangssignal von HIGH (VDD) auf LOW (0V). Im Fall eines Zähler-Überlaufs, also z.B. beim Übergang vom Zählerwert 65.535 auf 0, wird am Ausgang der PWM-Komparatorstufe 13.2a ein HIGH-Signal (VDD) ausgegeben.

Abhängig von den vorhandenen Bauteiltoleranzen wird auf diese Art und Weise somit ein anordnungsspezifischer PWM-Wert PWM_OUT_NOW für einen bestimmten Messwert MV_NOW eingestellt. Dies bedeutet, dass für eine bestimmte, kalibrierte Sensoranordnung ein anordnungsspezifischer Zusammenhang zwischen dem auszugebenden Messwert und dem PWM-Wert vorgegeben wird, der im Messbetrieb zur Erzeugung des analogen Ausgangssignals $U_{OUT}$ herangezogen wird. Aufgrund der in der Speichereinheit 14 dauerhaft abgelegten anordnungsspezifischen Korrekturparameter PWM_OUT_MIN, PWM_OUT_MAX kann dies über die gesamte Lebensdauer der jeweiligen Sensoranordnung berücksichtigt werden. Es lässt sich somit über die erfindungsgemäßen Maßnahmen die gesamte Sensoranordnung bestehend aus ASIC 10 und Verstärkereinheit 20 zuverlässig abgleichen bzw. sowohl eventuelle Bauteilschwankungen im ASIC 10 als auch in der Verstärkereinheit 20 kompensieren. Zur Kalibration ist es hierbei nicht erforderlich, die Sensoranordnung einer veränderten Temperatur auszusetzen; das heißt, der Kalibrierbetrieb kann durchgeführt werden, ohne die Temperatur der Sensoranordnung zu verändern.

Neben den vorstehend beschriebenen Ausführungsbeispielen existieren im Rahmen der vorliegenden Erfindung selbstverständlich noch weitere Ausgestaltungsmöglichkeiten.

So lässt sich z.B. auch eine Sensoranordnung erfindungsgemäß aufbauen, bei der ausgangsseitig über die Verstärkereinheit aus dem PWM-Signal ein analoges Stromsignal erzeugt wird usw..

**Patentansprüche**

1. Sensoranordnung, mit

   - mindestens einem Sensor (11, 12), der veränderliche physikalische Messgrößen (T, rH) erfasst und ausgangsseitig ein Sensor-Rohsignal (T_RAW, rH_RAW) bereitstellt,
   - einer digitalen Signalverarbeitungseinheit (13; 13.1, 13.2) zur Vorverarbeitung des vom Sensor (11, 12) bereitgestellten Sensor-Rohsignals (T_RAW, rH_RAW) in ein Sensor-Signal (T_ASIC, rH_ASIC), zur Weiterver-

arbeitung des Sensor-Signals (T_ASIC, rH_ASIC) in ein pulsweitenmoduliertes Ausgangssignal (PWM) mit einem von der Messgröße (T, rH) abhängigen Tastverhältnis (p), wozu in einer Speichereinheit (14) mehrere anordnungsspezifische Korrekturparameter (PWM_OUT_MIN, PWM_OUT_MAX) abgelegt sind, welche die Signalverarbeitungseinheit (13; 13.1, 13.2) zur Umsetzung des Sensor-Signals (T_ASIC, rH_ASIC) in das pulsweitenmodulierte Ausgangssignal (PWM) heranzieht, wobei als anordnungsspezifische Korrekturparameter (PWM_OUT_MIN, PWM_OUT_MAX) zumindest ein minimaler Tastverhältnisparameter-Grenzwert und ein maximaler Tastverhältnisparameter-Grenzwert in der Speichereinheit (14) abgelegt sind und
- einer Verstärkereinheit (20), die das pulsweitenmodulierte Ausgangssignal (PWM) in ein analoges Spannungs- oder Stromsignal ($U_{out}$) umsetzt.

2. Sensoranordnung nach Anspruch 1, wobei in der digitalen Signalverarbeitungseinheit (13; 13.1, 13,2) eine anordnungsspezifische Umsetzvorschrift abgelegt ist, die einen linearen Zusammenhang zwischen dem Messwert (MV_NOW) des Sensor-Signals (T_ASIC, rH_ASIC) und einem Tastverhältnisparameter (PWM_OUT_NOW) des pulsweitenmodulierten Ausgangssignals (PWM) beschreibt.

3. Sensoranordnung nach Anspruch 1, wobei in der Speichereinheit (14) ferner ein minimaler Sensor-Grenzmesswert (MV_OUT_MIN) und ein maximaler Sensor-Grenzmesswert (MV_OUT_MAX) abgelegt sind, die den Sensor-Messbereich begrenzen.

4. Sensoranordnung nach mindestens einem der Ansprüche 1-3, wobei als anordnungsspezifische Umsetzvorschrift die Beziehung

$$\text{PWM\_OUT\_NOW} = \text{MV\_NOW} \cdot k_{PWM} + d_{PWM}$$

in der digitalen Signalverarbeitungseinheit (13; 13.1, 13.2) abgelegt ist, mit

PWM_OUT_NOW := Tastverhältnisparameter des PWM-Signals

MV_NOW := Messwert des Sensors $\quad k_{PWM} := \dfrac{(PWM\_OUT\_MAX - PWM\_OUT\_MIN)}{(MV\_OUT\_MAX - MV\_OUT\_MIN)}$

$d_{PWM}$ := PWM_OUT_MIN - MV_OUT_MIN $\cdot k_{PWM}$
PWM_OUT_MAX := maximaler Tastverhältnisparameter-Grenzwert
PWM_OUT_MIN := minimaler Tastverhältnisparameter-Grenzwert
MV_OUT_MAX := maximaler Sensor-Grenzmesswert
MV_OUT_MIN := minimaler Sensor-Grenzmesswert

5. Sensoranordnung nach mindestens einem der vorhergehenden Ansprüche, wobei der mindestens eine Sensor (11, 12), die digitale Signalverarbeitungseinheit (13; 13.1, 13.2) sowie die Speichereinheit (14) gemeinsam in einem ASIC (10) angeordnet sind und die Verstärkereinheit (20) getrennt vom ASIC (10) ausgebildet ist.

6. Sensoranordnung nach Anspruch 5, wobei die Speichereinheit (14) als nichtflüchtige Speichereinheit ausgebildet ist.

7. Sensoranordnung nach mindestens einem der vorhergehenden Ansprüche, wobei die Verstärkereinheit (20) als Verstärkerschaltung mit einem Tiefpass ausgebildet ist.

8. Sensoranordnung nach mindestens einem der vorhergehenden Ansprüche mit zwei Sensoren (11, 12), von denen ein erster Sensor (11) als Temperatursensor und ein zweiter Sensor (12) als Feuchtesensor ausgebildet ist.

9. Verfahren zum Betrieb einer Sensoranordnung in einem Messbetrieb und in einem Kalibrierbetrieb, wobei

- im Messbetrieb

- über mindestens einen Sensor (11, 12) eine veränderliche physikalische Messgröße (T, rH) erfasst und ausgangsseitig ein Sensor-Rohsignal (T _RAW, rH_RAW) bereitgestellt wird, und
- über eine digitale Signalverarbeitungseinheit (13; 13.1, 13.2) das vom Sensor (11, 12) bereitgestellte Sensor-Rohsignal (T_RAW, rH_RAW) in ein Sensor-Signal (T_ASIC, rH_ASIC) vorverarbeitet wird und das Sensor-Signal (T_ASIC, rH_ASIC) in ein pulsweitenmoduliertes Ausgangssignal (PWM) mit einem von der Messgröße (T, rH) abhängigen Tastverhältnis umgesetzt wird, und
- über eine Verstärkereinheit (20), das pulsweitenmodulierte Ausgangssignal (PWM) in ein analoges Spannungs- oder Stromsignal ($U_{out}$) umgesetzt wird, und

- in einem dem Messbetrieb vorhergehenden Kalibrierbetrieb in einer Speichereinheit (14) mehrere anordnungsspezifische Korrekturparameter (PWM_OUT_MIN, PWM_OUT_MAX) abgelegt werden, welche von der Signalverarbeitungseinheit (13; 13.1, 13.2) im Messbetrieb zur Umsetzung des Sensor-Signals (T_ASIC, rH_ASIC) in das pulsweitenmodulierte Ausgangssignal (PWM) herangezogen werden, wobei als anordnungsspezifische Korrekturparameter (PWM_OUT_MIN, PWM_OUT_MAX) zumindest ein minimaler Tastverhältnisparameter-Grenzwert und ein maximaler Tastverhältnisparameter-Grenzwert in der Speichereinheit (14) abgelegt werden.

10. Verfahren nach Anspruch 9, wobei im Kalibrierbetrieb in der digitalen Signalverarbeitungseinheit (13; 13.1, 13.2) eine anordnungsspezifische Umsetzvorschrift abgelegt wird, die einen linearen Zusammenhang zwischen dem Messwert (MV_NOW) des Sensor-Signals (T_ASIC, RH_ASIC) und einem Tastverhältnisparameter (PWM_OUT_NOW) des pulsweitenmodulierten Ausgangssignals (PWM) beschreibt.

11. Verfahren nach Anspruch 9, wobei ferner ein minimaler Sensor-Grenzmesswert (MV_OUT_MIN) und ein maximaler Sensor-Grenzmesswert (MV_OUT_MAX) in der Speichereinheit (14) abgelegt werden, die den Sensor-Messbereich begrenzen.

12. Verfahren nach den Ansprüchen 9 - 11, wobei als anordnungsspezifische Umsetzvorschrift die Beziehung

$$PWM\_OUT\_NOW = MV\_NOW \cdot k_{PWM} + d_{PWM}$$

in der digitalen Signalverarbeitungseinheit (13; 13.1, 13.2) abgelegt wird, mit

PWM_OUT_NOW := Tastverhältnisparameter des PWM-Signals

MV_NOW := Messwert des Sensor-Signals $\qquad k_{PWM} := \dfrac{(PWM\_OUT\_MAX - PWM\_OUT\_MIN)}{(MV\_OUT\_MAX - MV\_OUT\_MIN)}$

$d_{PWM}$ := PWM_OUT_MIN - MV_OUT_MIN $\cdot k_{PWM}$
PWM_OUT_MAX := maximaler Tastverhältnisparameter-Grenzwert
PWM_OUT_MIN := minimaler Tastverhältnisparameter-Grenzwert
MV_OUT_MAX := maximaler Sensor-Grenzmesswert
MV_OUT_MIN := minimaler Sensor-Grenzmesswert

13. Verfahren nach mindestens einem der Ansprüche 9 - 12, wobei der Kalibrierbetrieb durchgeführt wird, ohne die Temperatur der Sensoranordnung zu verändern.

**Claims**

1. Sensor arrangement, having

- at least one sensor (11, 12) that records changeable physical measured variables (T, rH) and provides a sensor raw signal (T_RAW, rH_RAW) at output,
- a digital signal processing unit (13; 13.1, 13.2) for preprocessing the sensor raw signal (T_RAW, rH_RAW) provided by the sensor (11, 12) into a sensor signal (T_ASIC, rH_ASIC), for further processing the sensor signal (T_ASIC, rH_ASIC) into a pulse width-modulated output signal (PWM) having a duty cycle (p) dependent on the measured variable (T, rH), for which purpose a plurality of arrangement-specific correction parameters (PWM_OUT_MIN, PWM_OUT_MAX) are stored in a memory unit (14) and are used by the signal processing unit (13; 13.1, 13.2) to convert the sensor signal (T_ASIC, rH_ASIC) into the pulse width-modulated output signal (PWM), wherein at least a minimum duty cycle parameter limit value and a maximum duty cycle parameter limit value are stored in the memory unit (14) as arrangement-specific correction parameters (PWM_OUT_MIN, PWM_OUT_MAX), and
- an amplifier unit (20) that converts the pulse width-modulated output signal (PWM) into an analogue voltage or current signal ($U_{out}$)

2. Sensor arrangement according to Claim 1, wherein an arrangement-specific conversion rule is stored in the digital signal processing unit (13; 13.1, 13.2) and describes a linear relationship between the measured value (MV_NOW) of the sensor signal (T_ASIC, rH_ASIC) and a duty cycle parameter (PWM_OUT_NOW) of the pulse width-modulated output signal (PWM).

3. Sensor arrangement according to Claim 1, wherein the memory unit (14) furthermore stores a minimum sensor limit measured value (MV_OUT_MIN) and a maximum sensor limit measured value (MV_OUT_MAX) that define the sensor measurement range.

4. Sensor arrangement according to at least one of Claims 1 - 3, wherein the relationship

$$\texttt{PWM\_OUT\_NOW} = \texttt{MV\_NOW} \cdot \texttt{k}_{\texttt{PWM}} + \texttt{d}_{\texttt{PWM}}$$

is stored in the digital signal processing unit (13; 13.1, 13.2) as arrangement-specific conversion rule, where

PWM_OUT_NOW:= duty cycle parameter of the PWM signal

MV_NOW:= measured value from the sensor $\quad k_{PWM} := \dfrac{(PWM\_OUT\_MAX - PWM\_OUT\_MIN)}{(MV\_OUT\_MAX - MV\_OUT\_MIN)}$

$d_{PWM}$ := PWM_OUT_MIN - MV_OUT_MIN · $k_{PWM}$
PWM_OUT_MAX:= maximum duty cycle parameter limit value
PWM_OUT_MIN:= minimum duty cycle parameter limit value
MV_OUT_MAX:= maximum sensor limit measured value
MV_OUT_MIN:= minimum sensor limit measured value.

5. Sensor arrangement according to at least one of the preceding claims, wherein the at least one sensor (11, 12), the digital signal processing unit (13; 13.1, 13.2) and the memory unit (14) are arranged together in an ASIC (10) and the amplifier unit (20) is formed separately from the ASIC (10).

6. Sensor arrangement according to Claim 5, wherein the memory unit (14) is designed as a non-volatile memory unit.

7. Sensor arrangement according to at least one of the preceding claims, wherein the amplifier unit (20) is designed as an amplifier circuit with a low-pass filter.

8. Sensor arrangement according to at least one of the preceding claims, having two sensors (11, 12), a first sensor (11) of which is designed as a temperature sensor and a second sensor (12) of which is designed as a moisture sensor.

9. Method for operating a sensor arrangement in a measurement mode and in a calibration mode, wherein

- in the measurement mode
- at least one sensor (11, 12) records a changeable physical measured variable (T, rH) and provides a sensor raw signal (T_RAW, rH_RAW) at output, and
- a digital signal processing unit (13; 13.1, 13.2) preprocesses the sensor raw signal (T_RAW, rH_RAW) provided by the sensor (11, 12) into a sensor signal (T_ASIC, rH_ASIC) and converts the sensor signal (T_ASIC, rH_ASIC) into a pulse width-modulated output signal (PWM) having a duty cycle dependent on the measured variable (T, rH), and
- an amplifier unit (20) converts the pulse width-modulated output signal (PWM) into an analogue voltage or current signal ($U_{out}$), and
- in a calibration mode preceding the measurement mode, a plurality of arrangement-specific correction parameters (PWM_OUT_MIN, PWM_OUT_MAX) are stored in a memory unit (14) and are used by the signal processing unit (13; 13.1, 13.2), in the measurement mode, to convert the sensor signal (T_ASIC, rH_ASIC) into the pulse width-modulated output signal (PWM), wherein at least a minimum duty cycle parameter limit value and a maximum duty cycle parameter limit value are stored in the memory unit (14) as arrangement-specific correction parameters (PWM_OUT_MIN, PWM_OUT_MAX).

10. Method according to Claim 9, wherein, in the calibration mode, an arrangement-specific conversion rule is stored in the digital signal processing unit (13; 13.1, 13.2) and describes a linear relationship between the measured value (MV_NOW) of the sensor signal (T_ASIC, rH_ASIC) and a duty cycle parameter (PWM_OUT_NOW) of the pulse width-modulated output signal (PWM).

**11.** Method according to Claim 9, wherein the memory unit (14) furthermore stores a minimum sensor limit measured value (MV_OUT_MIN) and a maximum sensor limit measured value (MV_OUT_MAX) that define the sensor measurement range.

**12.** Method according to Claims 9 - 11, wherein the relationship

$$\texttt{PWM\_OUT\_NOW = MV\_NOW} \cdot \texttt{k}_{\texttt{PWM}} + \texttt{d}_{\texttt{PWM}}$$

is stored in the digital signal processing unit (13; 13.1, 13.2) as arrangement-specific conversion rule, where

PWM_OUT_NOW:= duty cycle parameter of the PWM signal

MV_NOW:= measured value of the sensor signal $\quad k_{PWM} := \dfrac{(PWM\_OUT\_MAX - PWM\_OUT\_MIN)}{(MV\_OUT\_MAX - MV\_OUT\_MIN)}$

$d_{PWM}$:= PWM_OUT_MIN - MV_OUT_MIN · $k_{PWM}$
PWM_OUT_MAX:= maximum duty cycle parameter limit value
PWM_OUT_MIN:= minimum duty cycle parameter limit value
MV_OUT_MAX:= maximum sensor limit measured value
MV_OUT_MIN:= minimum sensor limit measured value.

**13.** Method according to at least one of Claims 9 - 12, wherein the calibration mode is performed without changing the temperature of the sensor arrangement.

**Revendications**

**1.** Arrangement de capteur, comprenant

- au moins un capteur (11, 12), qui détecte des grandeurs mesurées (T, rH) physiques variables et fournit du côté de la sortie un signal brut de capteur (T_RAW, rH_RAW),
- une unité de traitement de signal (13 ; 13.1, 13.2) numérique destinée à prétraiter le signal brut de capteur (T_RAW, rH_RAW) fourni par le capteur (11, 12) en un signal de capteur (T_ASIC, rH_ASIC) en vue d'un post-traitement du signal de capteur (T_ASIC, rH_ASIC) en un signal de sortie modulé en largeur d'impulsion (PWM) ayant un rapport cyclique (p) dépendant de la grandeur mesurée (T, rH), ce pour quoi plusieurs paramètres de correction (PWM_OUT_MIN, PWM_OUT_MAX) spécifiques à l'arrangement sont stockés dans une unité de mémoire (14), lesquels sont utilisés par l'unité de traitement de signal (13 ; 13.1, 13.2) pour convertir le signal de capteur (T_ASIC, rH_ASIC) en le signal de sortie modulé en largeur d'impulsion (PWM), les paramètres de correction (PWM_OUT_MIN, PWM_OUT_MAX) spécifiques à l'arrangement stockés dans l'unité de mémoire (14) étant au moins une valeur limite de paramètre de rapport cyclique minimale et une valeur limite de paramètre de rapport cyclique maximale et
- une unité d'amplification (20) qui convertit le signal de sortie modulé en largeur d'impulsion (PWM) en un signal de tension ou de courant ($U_{out}$) analogique.

**2.** Arrangement de capteur selon la revendication 1, une règle de conversion spécifique à l'arrangement étant stockée dans l'unité de traitement de signal (13 ; 13.1, 13.2), laquelle décrit une relation linéaire entre la valeur mesurée (MV_NOW) du signal de capteur (T_ASIC, rH_ASIC) et un paramètre de rapport cyclique (PWM_OUT_NOW) du signal de sortie modulé en largeur d'impulsion (PWM).

**3.** Arrangement de capteur selon la revendication 1, une valeur mesurée limite de capteur minimale (MV_OUT_MIN) et une valeur mesurée limite de capteur maximale (MV_OUT_MAX) étant en outre stockées dans l'unité de mémoire (14), lesquelles délimitent la plage de mesure du capteur.

**4.** Arrangement de capteur selon au moins l'une des revendications 1 à 3, la relation

$$\texttt{PWM\_OUT\_NOW = MV\_NOW} \cdot \texttt{k}_{\texttt{PWM}} + \texttt{d}_{\texttt{PWM}}$$

étant stockée dans l'unité de traitement de signal (13 ; 13.1, 13.2) en tant que règle de conversion spécifique à l'arrangement, avec

PWM_OUT_NOW = paramètre de rapport cyclique du signal PWM

$$k_{PWM} = \frac{(PWM\_OUT\_MAX - PWM\_OUT\_MIN)}{(MV\_OUT\_MAX - MV\_OUT\_MIN)}$$

MV_NOW = valeur mesurée du capteur
$d_{PWM}$ = PWM_OUT_MIN - MV_OUT_MIN · kp$_{WM}$
PWM_OUT_MAX = valeur limite de paramètre de rapport cyclique maximale
PWM_OUT_MIN = valeur limite de paramètre de rapport cyclique minimale
MV_OUT_MAX = valeur mesurée limite de capteur maximale
MV_OUT_MIN = valeur mesurée limite de capteur minimale.

5. Arrangement de capteur selon au moins l'une des revendications précédentes, l'au moins un capteur (11, 12), l'unité de traitement de signal (13 ; 13.1, 13.2) ainsi que l'unité de mémoire (14) étant disposés ensemble dans un ASIC (10) et l'unité d'amplification (20) étant réalisée séparément de l'ASIC (10).

6. Arrangement de capteur selon la revendication 5, l'unité de mémoire (14) étant réalisée sous la forme d'une unité de mémoire non volatile.

7. Arrangement de capteur selon au moins l'une des revendications précédentes, l'unité d'amplification (20) étant réalisée sous la forme d'un circuit amplificateur comprenant un filtre passe-bas.

8. Arrangement de capteur selon au moins l'une des revendications précédentes, comprenant deux capteurs (11, 12), parmi lesquels un premier capteur (11) est réalisé sous la forme d'un capteur de température et un deuxième capteur (12) sous la forme d'un capteur d'humidité.

9. Procédé pour faire fonctionner un arrangement de capteur dans un régime de mesure et dans un régime d'étalonnage, selon lequel

- en régime de mesure

- une grandeur mesurée (T, rH) physique variable est détectée par le biais d'au moins un capteur (11, 12) un signal brut de capteur (T_RAW, rH_RAW) est fourni du côté de la sortie,
- le signal brut de capteur (T_RAW, rH_RAW) fourni par le capteur (11, 12) est prétraité par le biais d'une unité de traitement de signal (13 ; 13.1, 13.2) numérique en un signal de capteur (T_ASIC, rH_ASIC), et le signal de capteur (T_ASIC, rH_ASIC) est converti en un signal de sortie modulé en largeur d'impulsion (PWM) ayant un rapport cyclique dépendant de la grandeur mesurée (T, rH), et
- le signal de sortie modulé en largeur d'impulsion (PWM) est converti en un signal de tension ou de courant ($U_{out}$) analogique dans une unité d'amplification (20), et
- dans un régime d'étalonnage qui précède le régime de mesure, plusieurs paramètres de correction (PWM_OUT_MIN, PWM_OUT_MAX) spécifiques à l'arrangement sont stockés dans une unité de mémoire (14), lesquels sont utilisés par l'unité de traitement de signal (13 ; 13.1, 13.2) pour convertir le signal de capteur (T_ASIC, rH_ASIC) en le signal de sortie modulé en largeur d'impulsion (PWM), les paramètres de correction (PWM_OUT_MIN, PWM_OUT_MAX) spécifiques à l'arrangement stockés dans l'unité de mémoire (14) étant au moins une valeur limite de paramètre de rapport cyclique minimale et une valeur limite de paramètre de rapport cyclique maximale.

10. Procédé selon la revendication 9, selon lequel, dans le régime d'étalonnage, une règle de conversion spécifique à l'arrangement est stockée dans l'unité de traitement de signal (13 ; 13.1, 13.2), laquelle décrit une relation linéaire entre la valeur mesurée (MV_NOW) du signal de capteur (T_ASIC, rH_ASIC) et un paramètre de rapport cyclique (PWM_OUT_NOW) du signal de sortie modulé en largeur d'impulsion (PWM).

11. Procédé selon la revendication 9, selon lequel une valeur mesurée limite de capteur minimale (MV_OUT_MIN) et une valeur mesurée limite de capteur maximale (MV_OUT_MAX) sont en outre stockées dans l'unité de mémoire (14), lesquelles délimitent la plage de mesure du capteur.

12. Procédé selon les revendications 9 à 11, selon lequel la relation

$$\mathrm{PWM\_OUT\_NOW\ =\ MV\_NOW\ \cdot\ k_{PWM}\ +\ d_{PWM}}$$

est stockée dans l'unité de traitement de signal (13 ; 13.1, 13.2) en tant que règle de conversion spécifique à l'arrangement, avec

PWM_OUT_NOW = paramètre de rapport cyclique du signal PWM

MV_NOW = valeur mesurée du signal de capteur
$$k_{PWM} \ = \ \frac{(\mathrm{PWM\_OUT\_MAX} - \mathrm{PWM\_OUT\_MIN})}{(\mathrm{MV\_OUT\_MAX} - \mathrm{MV\_OUT\_MIN})}$$
$d_{PWM}$ = PWM_OUT_MIN - MV_OUT_MIN · $kp_{WM}$
PWM_OUT_MAX = valeur limite de paramètre de rapport cyclique maximale
PWM_OUT_MIN = valeur limite de paramètre de rapport cyclique minimale
MV_OUT_MAX = valeur mesurée limite de capteur maximale
MV_OUT_MIN = valeur mesurée limite de capteur minimale.

13. Procédé selon au moins l'une des revendications 9 à 12, selon lequel le régime d'étalonnage est exécuté sans modifier la température de l'arrangement de capteur.

# FIG. 1

# FIG. 2a

# FIG. 2b

EP 3 696 514 B1

# FIG. 3

$U_{out} = k * PWM + d$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7731417 B2